# EUROPEAN PATENT SPECIFICATION

(11) **EP 1 768 466 B1**
(45) Date of publication and mention of the grant of the patent: **20.01.2010**
(21) Application number: 06019656.5
(22) Date of filing: 27.04.2001
(51) Int. Cl.: H05B 33/14, C08F 38/00, C09K 11/06

(54) **Organic luminous material and organic light-emitting device**
Organischer lumineszenter Stoff und organisches lichtemittierendes Bauelement
Matière organique lumineuse et dispositif organique émetteur de lumière

(30) Priority: 27.04.2000 JP 2000128364; 22.09.2000 JP 2000288692; 24.04.2001 JP 2001125359
(43) Date of publication of application: 28.03.2007
(62) Divisional of application: 01303861.7
(73) Proprietor: FUJITSU LIMITED, Kawasaki-shi, Kanagawa 211-8588 (JP)
(72) Inventor: Yoshikawa, Kota, Kawasaki-shi Kanagawa 211-8588 (JP); Kijima, Masashi, Tsukuba-shi Ibaraki 305-8573 (JP); Shirakawa, Hideki, Yokohama-shi Kanagawa (JP); Kinoshita, Ikuo, Kanagawa 250-0012 (JP)
(74) Representative: Fenlon, Christine Lesley

(56) References cited:
- EP-A2- 0 299 384
- DE-A1- 3 910 260
- DE-A1- 4 339 646
- US-A- 4 895 975
- US-A- 5 876 864
- C. WEDER, M.S. WRIGHTON: "Efficient solid-state photoluminescence in new poly(2,5-dialkoxy-p-phenyleneethynylene)s" MACROMOLECULES, vol. 29, 1996, pages 5157-5165, XP002415717
- M. MORONI, J. LE MOIGNE, S. LUZZATI: "rIGID ROD CONJUGATED POLYMERS FOR NONLINEAR OPTICS. 1. CHARACTERIZATION AND LINEAR OPTICAL PROPERTIES OF POLY(ARYLENEETHYNYLENE) DERIVATIVES" MACROMOLECULES, vol. 27, 1994, pages 562-571, XP002415718
- X.T. TAO ET.AL.: "Novel main-chain poly-carbazoles as hole and electron transport materials in polymer light-emitting diodes" APPL. PHYS. LETT., vol. 71, no. 14, 1997, pages 1921-1923, XP002339411
- REMMERS M ET AL: "THE OPTICAL, ELECTRONIC, AND ELECTROLUMINESCENT PROPERTIES OF NOVELPOLY(P-PHENYLENE)-RELATED POLYMERS" MACROMOLECULES, AMERICAN CHEMICAL SOCIETY. EASTON, US, vol. 29, no. 23, 4 November 1996 (1996-11-04), pages 7432-7445, XP000631108 ISSN: 0024-9297
- YANG M ET AL: "Characterization and fluorescence properties of thiophene-modified pi-conjugated nickel poly-yne polymers" POLYMER, ELSEVIER SCIENCE PUBLISHERS B.V, GB, vol. 40, no. 11, May 1999 (1999-05), pages 3203-3209, XP004157673 ISSN: 0032-3861
- HOLZER W ET AL: "Excitation intensity-dependent fluorescence behaviour of some luminescent polymers" POLYMER, ELSEVIER SCIENCE PUBLISHERS B.V, GB, vol. 39, no. 16, July 1998 (1998-07), pages 3651-3656, XP004120980 ISSN: 0032-3861
- T. HATTORI ET.AL.: "Photoinduced absorption and luminescence in polydiacetylenes" J.PHS.C: SOLID STATE PHYS., vol. 17, 1984, pages L881-L888, XP002339413

## Description

The present invention relates to an organic luminous material and an organic light-emitting device and, more particularly, to an organic light-emitting device like an organic electroluminescence (EL) device employing such material.

In recent years, the research and development of an organic EL device applied to a flat display panel, a mobile display device, etc. has been vigorously pursued. A display device employing an organic EL device can provide high brightness and full color display by low voltage driving.

In addition, a display device consisting of an organic EL devices has features different from a liquid crystal display (LCD). For example, there can be provided a light weight and low cost product that has no viewing angle dependence because it is a spontaneously emissive display, does not need back lights because of the high contrast, has a quick response speed, has an easy film formation characteristic, and withstands impact since the overall device is constructed from solid state elements.

An organic EL device has a structure made up of lower electrode formed of transparent conductive material, an organic thin film (luminous layer), and an upper electrode formed of magnesium, potassium, etc. formed in sequence on the glass substrate, for example. The thickness of the overall structure can be reduced up to about several mm. Then, light is emitted from the luminous layer by applying a DC voltage between the lower electrode and the upper electrode, and this light is passed through the lower electrode and the glass substrate to output to the outside. The organic EL device is an injection electroluminescence device that increases the number of carriers in operation by injecting the carriers from the electrode to thus emit light by recombination. Sometimes the organic EL device is also called an organic LED.

As the luminous material employed in the organic thin film of the organic EL device, there are used monomer materials and polymer materials. Normally a film of monomer material is formed by the vacuum evaporation method, and normally a film of polymer material is formed by a coating method. Coating methods are practical in device formation because expensive equipment is not needed.

D. Comoretto et al., "Long-lived photoexcited states in polydiacetylenes with different molecular and supramolecular organization", Physical Review B, Volume 56, Number 16, 15 October 1997, pp 10264-10270, discusses the photoinduced absorption spectra of the red form of poly[1,6-bis(3,6-didoecyl-N-carbazolyl)-2,4-hexadiyne] (polyDCHD-S) and the results compared with those of the blue form of the same polymer.

H. N. Cho et al., "Statistical Copolymers for Blue-Light-Emitting Diodes", Macromolecules 1999, 32, 1476-1481, discloses the fabrication of blue-light-emitting diodes using fluorene-based statistical copolymers with m- and p-divinylbenzene.

It is known to employ PPV (poly p-phenylenevinylene) as the polymer material. An EL device employing such material is set forth in Patent Application Publication (KOKAI) Hei 10-326675, for example.

A conjugated polymer material such as PPV employed as the luminous layer in the prior art is in a highly crystalline state at normal temperature, unlike a normal polymer material.

Accordingly, if such conjugated polymer material is formed on the substrate, unevenness readily occurs on the surface of the luminous layer made of the polymer.

If a voltage is applied between the lower electrode and the upper electrode under conditions such that unevenness is present on the surface of the luminous layer, the electric field is readily concentrated in the concave portion of the surface of the luminous layer. Thus, there is the possibility that the luminous layer is destroyed by the electric field, and then a short-circuit is caused between the lower electrode and the upper electrode.

Also, since the luminous polymer layer in the prior art, which is readily crystallised, is insoluble in the organic solvent, treatment must be applied, e.g., the polymer must be mixed into the organic solvent while being heated, when the polymer is coated on the substrate, and thus it is not easy to handle the polymer. In addition, even if the conjugated polymer in the prior art is dissolved in the organic solvent, such polymer is still readily crystallized after cooling.

It is an object of the present invention to provide a light-emitting device having a luminous layer formed of polymer material that can be highly planarized and has a solubility in organic solvents higher than that of polymer film material in the prior art.

According to a first aspect of the the present invention there is provided an organic luminous material having the general formula 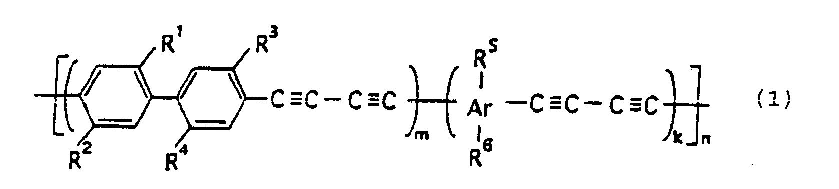 where Ar denotes an arylene group, R¹, R², R³, R⁴, R⁵ and R⁶, denote substituents which can be the same or different or some of which can be the same and other(s) different, m and k denote the copolymerization ratio and n denotes the degree of polymerisation; wherein the said substituents are selected from hydrogen, alkyl, alkoxy, carboxyl, cyano, phenyl, biphenyl, and cyclohexylphenyl; and wherein 0<m<1 and m+k=1.

The aromatic ring constituting the arylene group can be any one of benzene, pyrrole, thiophene, carbazole, furan, fluorene, naphthalene, anthracene or derivatives thereof.

Such a luminous material can emit light in the blue or near blue color wavelength band.

According to a second aspect of the present invention there is provided an organic light-emitting device comprising: a lower electrode; a luminous layer formed on the lower electrode, which is the organic luminous material embodying the first aspect of the present invention; and an upper electrode formed on the luminous layer.

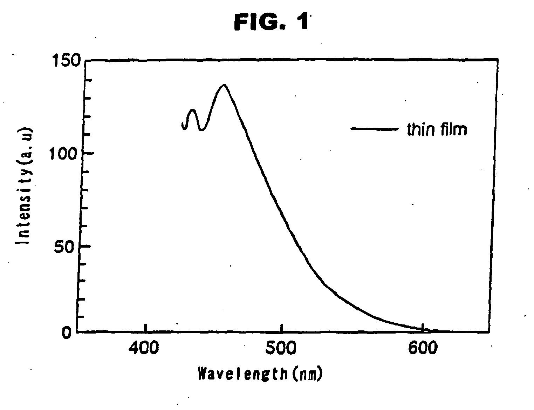

For a better understanding of the invention, and to show how the same may be carried into effect, reference will now be made, by way of example, to the accompanying drawings, in which:-
FIG.1 is a graph showing the fluorescent spectrum of a blue color luminous layer employed in an organic EL device according to the present invention.

An embodiment of the present invention will be explained, with reference to the accompanying drawing hereinafter.

In order to display a full color image on the organic EL display device, a polymer that can emit blue color light is required. Therefore, polymers that can emit light in the blue color wavelength band will be explained hereunder.

Copoly(4,4'-biphenylylenebutadiynylene)(4-dodecyloxy-m-phenylenebutadiynylene) as given by the chemical formula (20) is an example of a copolymerized polymer for constituting a blue color luminous layer 3. The spectrum of the polymer having the formula (20) is shown in FIG.6 and has peaks at 428 nm and 450 nm in the luminous wavelength band.

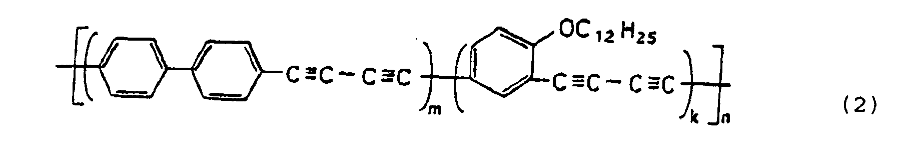

The polymer having the chemical formula (2) is synthesised as follows.

First, 4,4'-bis(trimethylsilylethynyl)biphenyl is synthesised by the reaction (3).

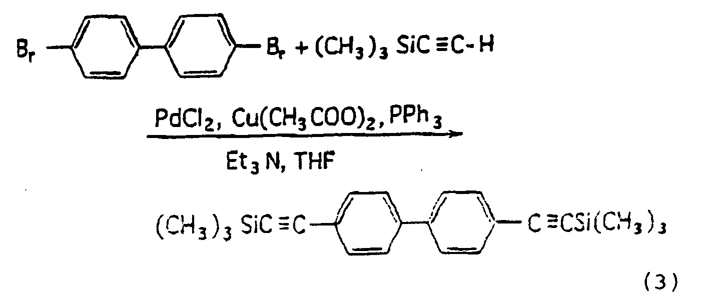

More particularly, reaction (3) is brought about by adding 6.24 g (20 mmol) of 4,4'-dibromobiphenyl, 354 mg (2 mmol) of palladium chloride, 364 mg (2 mmol) of copper acetate (Cu(CH₃CO0)₂), 1.73 g (6.6 mmol) of triphenylphosphine and 3.24 g (3.3 mmol) of trimethylsilylacetylene to a liquid that contains 100ml of triethylamine and 130 ml of THF under an argon atmosphere, and then refluxing this liquid at 85°C overnight. Then, 5.90 g (17 mmol) of white plate-like crystals are obtained as a yield of 85.0% by extracting the liquid with dichloromethane and water, then processing the resultant oily layer using silica gel column chromatography using the dichloromethane as developing solvent, and then purifying the oil obtained by recrystallisation from methanol.

The white plate-like crystals of 4'-bis(trimethylsilylethynyl)biphenyl have the formula shown on the right side of reaction (3).

Then, 4,4'-diethynylbiphenyl is synthesised from this reaction product by the reaction (4).

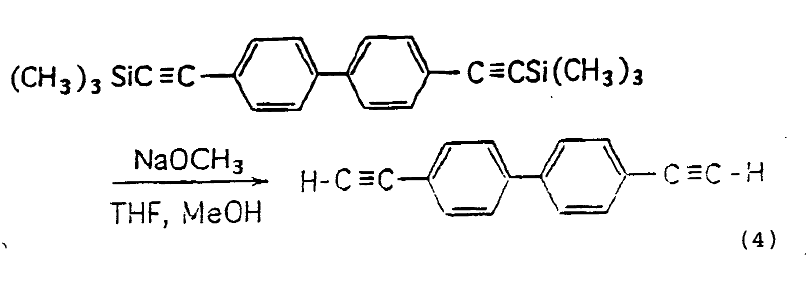

In other words, 5.9 g (17 mmol) of the white plate-like crystals are dissolved in 10ml of THF, then 1.83 g t34 mmol) of sodium methoxide (NaOCH₃) dissolved in the 6ml of methanol (CH₃OH; MeOH) are added to this solution, and then they are reacted at ambient temperature for three hours. Then, an oily layer is obtained by extraction using dichloromethane and 10% hydrochloric acid aqueous solution.

The oily layer is purified using a silica gel column employing developing solvent that contains dichloromethane and hexane at a ratio of 1:1, whereby a 1.20 g (5.9 mmol) of a white powder is obtained as a yield of 34.8%. This white powder is 4,4'-diethynylbiphenyl shown on the right side of reaction (4).

Then, copoly(4,4'-biphenylenebutadiynylene) (4-dodecyloxy-m-phenylenebutadiynylene)) is synthesised by reaction (5) using the white powder as starting material.

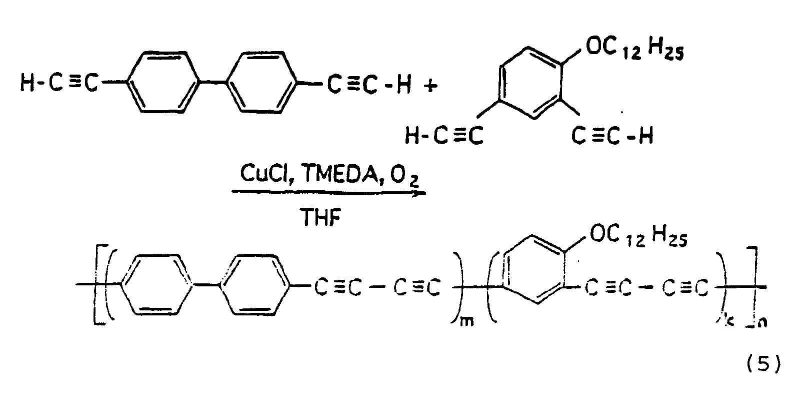

More particularly, a catalyst solution is formed by putting 20 mg (0.2 mmol) of copper (I) chloride, 24mg (0.2 mmol) of TMEDA, and 40 ml of THF into a vessel to react with each other, and then supplying oxygen to this reaction solution. Then, 4,4'-diethylbiphenyl and 311 mg (1 mmol) of 4-dodecyloxy-m-diethynylbenzene, each dissolved in 40 ml THF, are added to the catalyst solution, and then they are stirred under the oxygen atmosphere for two days. The 4-dodecyloxy-m-diethynylbenzene is expressed by the second chemical structural formula appearing in reaction (5). Reaction (5) progresses during this stirring, then the resultant reaction solution is dropped into 500 ml of 2-normal methanol/hydrochloric acid, and then the resultant precipitate is recovered. Then, this precipitate is dissolved in chloroform to remove the insoluble component, then this solution is dropped into 500 ml of methanol and then the resultant precipitate is recovered, whereby 248 g (0.98 mmol) of white powder are obtained as a yield of 48.7 %. This white powder is the polymer given by the formula (2). When this polymer is employed as a luminous layer 3, the luminous layer 3 emits a blue light or a light close to blue.

A general formula for the polymer (2) is expressed by the formula (6),

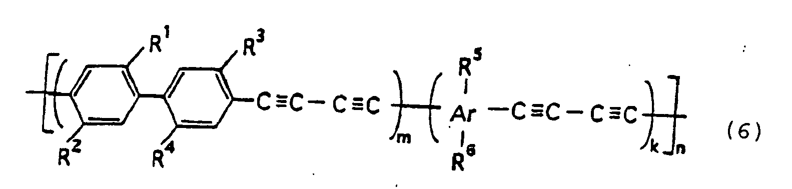

In the formula (6), Ar denotes an arylene group that can be any one of benzene, pyrrole, thiophene, carbazole, furan, fluorene, naphthalene, anthracene or each derivative of them. Also, R¹, R², R³, R⁴, R⁵ and R⁶ can be the same or different and can be any one of hydrogen, alkyl, alkoxyl, carboxyl, cyano, phenyl, biphenyl, and cyclohexylphenyl. Again, m and k denote the co-polymerization ratio, and n denotes the degree of polymerization.

As described above, according to the present invention, a luminous layer made of the polymer of formula (6) is formed between the lower electrode and the upper electrode. In contrast to the polymers employed as the luminous layer the prior art, such polymer is hard to crystallize at ambient temperature and has a high solubility in solvents.

Accordingly, if this polymer is employed as the luminous layer, planarization of the luminous layer can be facilitated, short-circuiting between the upper electrode and the lower electrode hardly occurs, and the yield of the device can be improved.

## Claims

1. An organic luminous material having the general formula 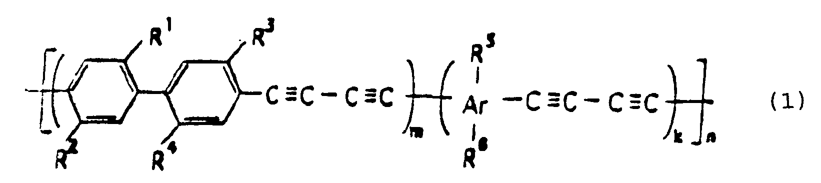 where Ar denotes an arylene group, R¹, R², R³, R⁴, R⁵ and R⁶, denotes substituents which can be the same or different or some of which can be the same and other(s) different, m and k denote the copolymerization ratio and n denotes the degree of polymerisation;
wherein the said substituents are selected from hydrogen, alkyl, alkoxy, carboxyl, cyano, phenyl, biphenyl and cyclohexylphenyl; and
wherein 0<m<1 and m+k=1.

2. An organic luminous material according to claim 1, wherein an aromatic ring constituting the arylene group is any one of benzene, pyrrole, thiophene, carbazole, furan, fluorene, naphthalene, anthracene and derivatives thereof.

3. An organic light-emitting device comprising:
a lower electrode;
a luminous layer formed on the lower electrode, which is the organic luminous material as claimed in claim 1 or 2; and
an upper electrode formed on the luminous layer.

## Patentansprüche

1. Organisches Leuchtmaterial mit der allgemeinen Formel: 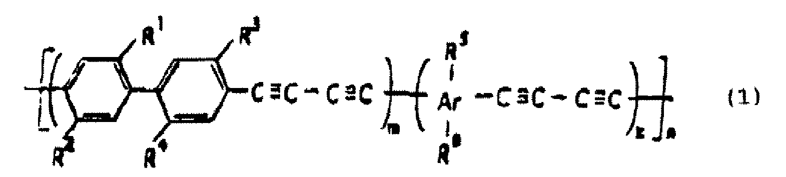 wobei Ar eine Arylengruppe bezeichnet, R¹, R², R³, R⁴, R⁵ und R⁶ Substituenten bezeichnen, die dieselben oder verschieden sein können oder von denen einige dieselben und ein anderer (andere) verschieden sein können, m und k das Copolymerisationsverhältnis bezeichnen und n den Polymerisationsgrad bezeichnet;
bei dem die Substituenten ausgewählt sind aus Wasserstoff, Alkyl, Alkoxy, Carboxyl, Cyano, Phenyl, Biphenyl und Cyclohexylphenyl; und
bei dem 0<m<1 und m+k=1 ist.

2. Organisches Leuchtmaterial nach Anspruch 1, bei dem ein aromatischer Ring, der die Arylengruppe bildet, eines umfasst von Benzol, Pyrrol, Thiophen, Carbazol, Furan, Fluoren, Naphthalen, Anthracen und Derivaten derselben.

3. Organische lichtemittierende Vorrichtung mit:
einer unteren Elektrode;
einer Leuchtschicht, die auf der unteren Elektrode gebildet ist und aus dem organischen Leuchtmaterial nach Anspruch 1 oder 2 ist; und
einer oberen Elektrode, die auf der Leuchtschicht gebildet ist.

## Revendications

1. Matière lumineuse organique répondant à la formule générale 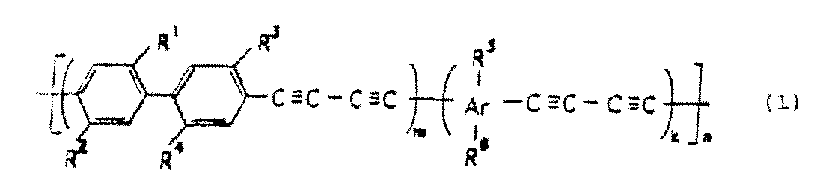 où Ar désigne un groupe arylène, R¹, R², R³ R⁴ R⁵ et R⁶ désignent des substituants qui peuvent être identiques ou différents ou dont certains peuvent être identiques et d'autre(s) différent(s), m et k désignent le rapport de copolymérisation et n désigne le degré de polymérisation ;
où lesdits substituants sont choisis parmi un atome d'hydrogène, un groupe alkyle, alcoxy, carbonyle, cyano, phényle, biphényle et cyclohexylphényle ; et
où 0 < m < 1 et m + k = 1.

2. Matière lumineuse organique selon la revendication 1, dans laquelle un cycle aromatique constituant le groupe arylène est un élément quelconque parmi benzène, pyrrole, thiophène, carbazole, furanne, fluorène, naphtalène, anthracène et leurs dérivés.

3. Dispositif électroluminescent organique comprenant :
une électrode inférieure ;
une couche lumineuse formée sur l'électrode inférieure, qui est la matière lumineuse organique telle que revendiquée dans la revendication 1 ou 2 ; et
une électrode supérieure formée sur la couche lumineuse.
